# EUROPEAN PATENT APPLICATION

(11) **EP 4 718 706 A1**
(43) Date of publication of application: **01.04.2026**
(21) Application number: 25204555.4
(22) Date of filing: 25.09.2025
(51) Int. Cl.: H02M 7/487, H02M 7/00, H02M 1/44, H10W 90/00

(54) **A POWER MODULE COMPRISING A THREE-LEVEL ACTIVE NEUTRAL POINT CLAMP TOPOLOGY, AS WELL AS A CORRESPONDING METHOD AND AN ASSEMBLY**

(30) Priority: 25.09.2024 NL 2038714
(71) Applicant: Nexperia B.V., 6534 AB Nijmegen (NL)
(72) Inventor: Simpson, Robin, Manchester (GB); Högerl, Jürgen, Hamburg (DE); Meng, Xiangfei, Hong Kong (HK)
(74) Representative: Pjanovic, Ilija

(57) **Abstract**

A power module comprising a three-level active neutral point clamp topology comprising at least six devices comprising two inner switches, two outer switches and two clamping devices, a sandwich structure comprising a first sub-assembly, wherein the first sub-assembly comprises the first inner switch, the first clamping device and the first inner switch and a second sub-assembly, wherein the second sub-assembly comprises the second inner switch, the second clamping device and the second inner switch, wherein the sandwich structure is arranged such that the first inner switch faces the second inner switch, such that the first outer switch faces the second clamping device and such that the first clamping device faces the second outer switch, a conductive connection element connecting the first and second inner switches.

## Description

### Technical field

The present disclosure relates to a power converter topology, specifically a Three-Level Active Neutral Point Clamp, 3L-ANPC, topology, which is widely used in high-voltage applications

### Background

Three-Level Active Neutral Point Clamp, 3L-ANPC, is widely used in high-voltage applications. It comprises three voltage levels per phase, which can have benefits over a two-layer half-bridge topology in some applications. It has three specific advantages.

First, it allows for GaN HEMTs (Gallium Nitride High Electron Mobility Transistor) which are fast switching transistors, these are typically limited to 650V, but can be used in higher voltage applications when using the 3L-ANPC, as each transistor is required to withstand only half of the application voltage.

The second is related to the short circuit resilience. The GaN HEMTs have limited short-circuit resilience. Therefore, positions requiring slower switching speeds are populated with traditional transistors with a slower switching speed, but have a higher short-circuit resilience. These transistors then protect the whole topology.

Third, the EM (electromagnetic) interference can be reduced through the introduction of the third voltage level, improving the smoothness of the output voltage form.

To realise this topology, typically six switches are used, which produce four commutation loops. Two loops comprising two switches each and two loops comprising four switches each. It is of importance to reduce the parasitic inductance in the loops, as it interacts with current transients to generate voltage spikes and oscillations in the loops. These have a risk of damaging or destroying the switches. Therefore, the parasitic inductance poses a reliability issue.

To decrease the parasitic inductance in the loops, the physical size of the loops should be decreased. However, to achieve this for four loops comprising multiple switches is challenging and requires compromises in the design.

### Summary

It would be advantageous to achieve a power module, in particular a power module comprising a Three-Level Active Neutral Point Clamp topology which reduces the parasitic inductance in commutation loops, thereby improving the reliability and performance of the power module. It would further be advantageous to achieve a method of manufacturing this power module.

In a first aspect of the present disclosure, there is provided a power module comprises a three-level active neutral point clamp topology. The power module comprising:
- at least six devices comprising two inner switches (S2, S3), two outer switches (S1, S4) and two clamping devices (S5, S6), wherein:
   - a first of said two outer switches is connected to a positive Direct Current, DC, terminal, and a second of said two outer switches is connected to a negative DC terminal;
   - a first of said two inner switches is connected to the first outer switch and to an Alternating Current, AC, terminal and wherein a second of said two inner switches is connected to the second outer switch and said AC terminal;
   - a first of said two clamping devices is connected to said first outer switch and to a neutral terminal (N), and wherein a second of said two clamping devices is connected to said second outer switch and to said neutral terminal;
- a sandwich structure comprising:
   - a first sub-assembly, wherein the first sub-assembly comprises the first inner switch, the first clamping device and the first outer switch;
   - a second sub-assembly, wherein the second sub-assembly comprises the second inner switch, the second clamping device and the second outer switch;
      wherein the sandwich structure is arranged such that the first inner switch faces the second inner switch, such that the first outer switch faces the second clamping device and such that the first clamping device faces the second outer switch;
   - a conductive connection element connecting the first and second inner switches.

The inventors have found that it may be beneficial to provide a power module which comprises of at least six devices, comprising of at least two inner switches at least two outer switches and at least two clamping devices, connected in two sub-assemblies arranged in a two-layer topology.

In this topology, four commutation loops may be identified, by utilizing the at least six devices. This two-layer topology allows a reduction in the physical size of the circuit, thereby decreasing the parasitic inductance in the system.

It is advantageous to prioritise the four commutation loops regarding which are most promising to minimise. In operation of the power module, there are typically two stages: the input stage and the output stage.

The input stage may require operation of the switches in loops 1 and 2. Switching is performed with low frequency. Loops 1 and 2 are referred to as input loops from hereon. The input stage may comprise the two outer switches and may further comprise the two clamping devices. The first loop is identified by the first outer switch in combination with the first clamping device. The second loop is identified by the second clamping device in combination with the second outer switch.

The output stage may require operation of switches in loops 3 and 4, specifically operation of the first inner switch and the second inner switch, at high switching frequency. Loops 3 and 4 are referred to as output loops from hereon. Considering this, it can be understood that minimising the inductance in output loops 3 and 4 may be prioritised.

To improve the loop dimensions, the power module in accordance with the present disclosure may split the switches/devices across two layers as illustrated later in the figures. Each input loop, i.e. loops 1 and 2 as identified above, is located on a single layer, while each output loop is distributed across the two layers.

In other words, the input loops are identified within a sub-assembly. The output loops are identified across sub-assemblies.

The switches/devices on each layer are arranged so that those in each output loop directly overlay one another to form what may be referred to as a stripline structure with a reduced possible loop length. A stripline structure overlays the widest faces of conductors carrying currents in opposing directions with a very small separation between the conductors.

This power module has, amongst other, the following benefits.

The opposing directions of current flow in the corresponding conductors generate a negative mutual inductance between the conductors, which subtracts from the self-inductance of the conductors in the loop, reducing the overall loop inductance.

Positioning the conductors with reduced separation reduces the loop area. The separation distance is that between the centroids of the conductors, so orientation with the widest faces adjacent to one another, as opposed to thin edge facing thin edge, with a small gap between the conductors reduces the distance between the centroids.

Application of the stripline concept to the power module comprising the switches in the output loop creates a very small physical loop size and improves the benefits from generation of negative mutual inductance. In the present disclosure, improving the input loop may have lower priority, so the stripline structure may not be employed at the input loop. However, moving the output loop off a single plane enables the input loop components to be placed directly next to one another for small lateral loop size.

In an example, the two inner switches comprise GaN HEMT transistors and the two outer switches and the two clamping devices comprise Si IGBTs (Silicon Insulated Gate Bipolar Transistors) and a corresponding anti-parallel diode.

The inventors have found that it may be beneficial to use GaN HEMT transistors for the two inner switches, as the two inner switches are being controlled with a relatively high frequency signal. The other transistors, i.e. the outer switches and, possibly, the clamping devices, may be realized using Si IGBTs and a corresponding anti-parallel diode as these switches do not require a high frequency capability.

In another example, the two clamping devices comprise diodes, thereby annulling their switching potential, but allowing the same commutation loops to remain.

In another example of the present disclosure, the first sub-assembly may comprise:
- a first interconnect arranged for connecting the first inner switch with the first outer switch and with the first clamping device.

In another example of the present disclosure, the second sub-assembly may comprise:
- a second interconnect arranged for connecting the first inner switch with the first outer switch and with the first clamping device.

In another example of the present disclosure the first and/or second interconnect comprises a clip-like structure, or a wire- or ribbon-bonding comprising of copper and/or aluminium.

The above-mentioned interconnects may, for example, be realized as a metal plate, or similar. The interconnect may have certain dimensions, for example width and/or height, such that the interconnects are able to support the current flowing there through. Further, the interconnects may be substantially flat for improving the manufacturing process.

In another example of the present disclosure the power module may further comprise:
- a central substrate positioned in between the first and second sub-assembly, wherein the central substrate comprises the AC terminal, the positive DC terminal, the negative DC terminal and the neutral terminal.

The advantage of this particular example is that the substrate may be used for connecting the AC terminal, the positive DC terminal, the negative DC terminal and the neutral terminal in an efficient manner.

In another example of the present disclosure the central substrate may comprise any of a printed circuit board or a conductive lead frame.

In another example of the present disclosure the power module comprises a duplicated switch for duplicating one of said at least six devices, wherein said duplicated switch is placed in parallel or in series of said one of said at least six devices.

In another example of the present disclosure, wherein said duplicated switch is of a same type as said one of said at least six devices.

In a second aspect of the present disclosure, there is provided a method of manufacturing a power module in accordance with the present disclosure, wherein the method comprises the steps of:
- providing the first sub-assembly;
- providing the second sub-assembly;
- sandwiching the first sub-assembly and the second sub-assembly such that a sandwich structure is obtained, wherein the sandwich structure is arranged such that the first inner switch faces the second inner switch, such that the first outer switch faces the second clamping device and such that the first clamping device faces the second outer switch.

It is noted that the advantages as explained with reference to the first aspect of the present disclosure, being the power module, are also applicable to the second aspect of the present disclosure, being the method of manufacturing such a power module.

In an example of the method disclosed in the present disclosure, wherein the method comprises the step of:
- providing a first interconnect at said first sub-assembly, such that said first interconnect connects the first inner switch with the first outer switch and with the first clamping device.

In another example of the method disclosed in the present disclosure, wherein the method further comprises the step of:
- providing a second interconnect at said second sub-assembly, such that said first interconnect connects the first inner switch with the first outer switch and with the first clamping device.

In another example of the method disclosed in the present disclosure, wherein the method further comprises the step of:
- providing a central substrate positioned in between the first and second sub-assembly, wherein the central substrate comprises the AC terminal, the positive DC terminal, the negative DC terminal and the neutral terminal.

In a third aspect of the present disclosure, there is provided an assembly of the power module according to the present disclosure, wherein the sandwich structure is encapsulated, wherein the encapsulation comprises an insulating material comprising epoxy-based resins, silicones or other insulative materials.

In an example of the assembly in accordance with the present disclosure, wherein the first sub-assembly and the second sub-assembly are each encapsulated separately

### Brief description of the figures

Fig. 1A & 1B depict the power module, with commutation loops, in accordance with the present disclosure;
Fig 1C to 1F depict the power module components, in accordance with the present disclosure.
Fig. 2A & 2B depict the current path taken in the power modules depicted in Figs. 1A to 1F.
Fig. 3A & 3B depict a schematic version of the power module, with commutation loops, in accordance with the present disclosure;
Fig. 4A & 4B depict sub-assemblies of the power module, in accordance with the present disclosure;
Fig. 5A & 5B depict the profile view of the sub-assembly as disclosed in Fig. 4A.
Fig. 5C & 5D depict the profile view of the power module, comprising stacked sub-assemblies as disclosed in Fig. 5A & 5B;
Fig. 6A & 6B depict an example of sub-assemblies of the power module, in accordance with the present disclosure;
Fig. 7A & 7B depict the profile view of the sub-assembly as disclosed in Fig. 6A.
Fig. 7C & 7D depict the profile view of the power module, comprising stacked sub-assemblies as disclosed in Fig. 7A & 7B;
Fig. 8A depict the profile view of the power module, comprising an example of stacked sub-assemblies comprising lateral semiconductor devices;
Fig. 8B & 8C depict the profile view of the power module, comprising an example of stacked sub-assemblies comprising vertical semiconductor devices;
Fig. 9A & 9B depict the profile view of the power module, comprising an example of stacked sub-assemblies comprising separate AC terminals;
Fig. 10A & 10B depict the profile view of the power module, comprising an example of stacked sub-assemblies omitting the insulating substrate;
Fig. 11 depicts the power module, comprising semiconductor devices in parallel;
Fig. 12 depicts the power module, comprising semiconductor devices in parallel.

### Detailed description

It is noted that in the description of the figures, same reference numerals refer to the same of similar components performing a same of essentially similar function.

A more detailed description is made with reference to particular examples, some of which are illustrated in the appended drawings, such that the features of the present disclosure may be understood in more detail. It is noted that the drawings only illustrate typical examples and are therefore not to be considered to limit the scope of the subject matter of the claims. The drawings are incorporated for facilitating an understanding of the disclosure and are thus not necessarily drawn to scale. Advantages of the subject matter as claimed will become apparent to those skilled in the art upon reading the description in conjunction with the accompanying drawings.

The ensuing description above provides preferred exemplary embodiment(s) only, and is not intended to limit the scope, applicability, or configuration of the disclosure. Rather, the ensuing description of the preferred exemplary embodiment(s) will provide those skilled in the art with an enabling description for implementing a preferred exemplary embodiment of the disclosure, it being understood that various changes may be made in the function and arrangement of elements, including combinations of features from different embodiments, without departing from the scope of the disclosure.

Unless the context clearly requires otherwise, throughout the description and the claims, the words "comprise," "comprising," and the like are to be construed in an inclusive sense, as opposed to an exclusive or exhaustive sense; that is to say, in the sense of "including, but not limited to." As used herein, the terms "connected," "coupled," or any variant thereof means any connection or coupling, either direct or indirect, between two or more elements; the coupling or connection between the elements can be physical, logical, electromagnetic, or a combination thereof. Additionally, the words "herein," "above," "below," and words of similar import, when used in this application, refer to this application as a whole and not to any particular portions of this application. Where the context permits, words in the Detailed Description using the singular or plural number may also include the plural or singular number respectively. The word "or" in reference to a list of two or more items, covers all the following interpretations of the word: any of the items in the list, all of the items in the list, and any combination of the items in the list.

These and other changes can be made to the technology considering the following detailed description. While the description describes certain examples of the technology, and describes the best mode contemplated, no matter how detailed the description appears, the technology can be practiced in many ways. Details of the system may vary considerably in its specific implementation, while still being encompassed by the technology disclosed herein.

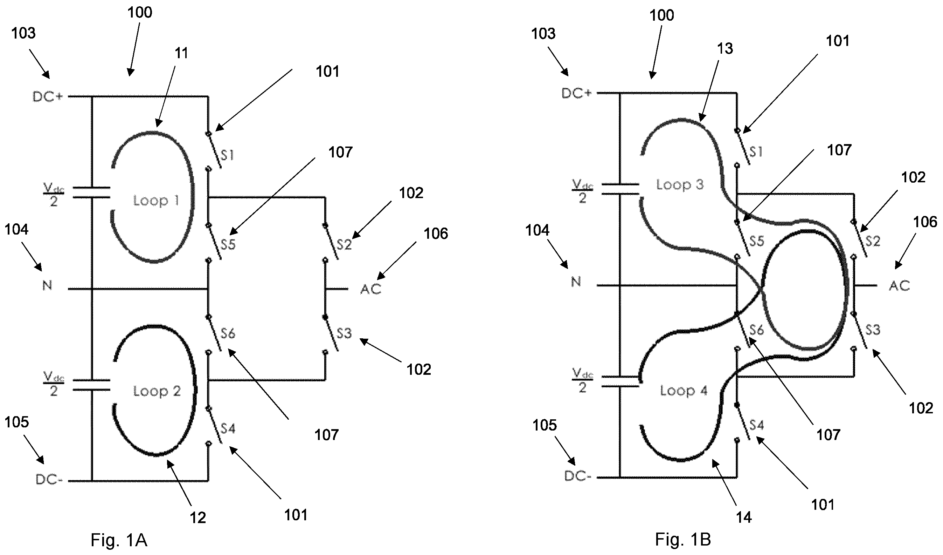

Figure 1A & 1B depict a circuit diagram 100 in accordance with the present disclosure, wherein the circuit diagram is related to a 3L-ANPC topology. In the circuit, six devices are used to provide four different, distinct, commutation loops 11, 12, 13 and 14. A commutation loop describes regions (or areas) encompassing the switches and connections between them and other components of the electronic circuit (or module) in which the current changes from one path to another during a switching event. These areas bounded by the physical loops create a parasitic inductance in the circuit. During the switching events, the combination of this parasitic inductance and the rate of change of current generates a voltage spike. The present disclosure minimises this voltage spike - thus maximizing the possible switching speed - by minimizing the loop area which maximizes the rate of change of current,

These devices may comprise switches. Two of these devices are "faster" switching switches 102, typically comprising GaN HEMTs. These switches are called the inner switches 102. Two of the six devices are "slower" switching switches 101, typically comprising Si IGBTs. These two devices are called outer switches 101.

The remaining two devices may comprise two "slower" switches 107, typically comprising Si IGBTs, or they may comprise two diodes 107. In any case these two remaining devices are called clamping devices 107.

Figures 1A and 1B depict the commutation loops 11, 12, 13 and 14 mentioned above, wherein Loop 1 (S1 and S5, commutation loop 11) and loop 2 (S4 and S6, commutation loop 12) in Figure 1A comprise two switches each. In the alternative each of these loops may comprise a single switch in combination with a diode.

Loop 3 (S1, S2, S3 and S6. Commutation loop 13) and loop 4 (S2, S3, S4 and S5, commutation loop 14) in Figure 1B comprise four switches each. In the alternative, these loops 3, 4 may comprise three switches in combination with a diode. That is, the device S5 and S6 may comprise diodes.

Further, in this circuit diagram the power terminals are depicted, namely the Direct Current, DC, terminals, both DC+ 103 and DC- 105 as well as the Alternating Current, AC, terminal 106 and the neutral, N, terminal 104.

It may be of importance to reduce the parasitic inductance in these loops. Parasitic inductance interacts with current transients to generate voltage spikes and oscillations in the loop. Moderate voltage spikes and oscillations can cause electromagnetic interference, which may need to be managed with filter circuitry and physical shielding.

Excessive voltage spikes and oscillations may cause spurious switching events, through coupling to the gate circuitry through parasitic capacitances, which have the potential to cause destruction of the switches. The voltage spikes may also exceed the absolute maximum rating of the switches, potentially destroying them.

A determinant of the parasitic inductance in the loops is their physical size. To reduce the inductance, the size of the loops may need to be reduced. However, to achieve this for four different loops comprising different combinations of switches is challenging and requires compromises in the design. This is elaborated in more detail with reference to the figures below.

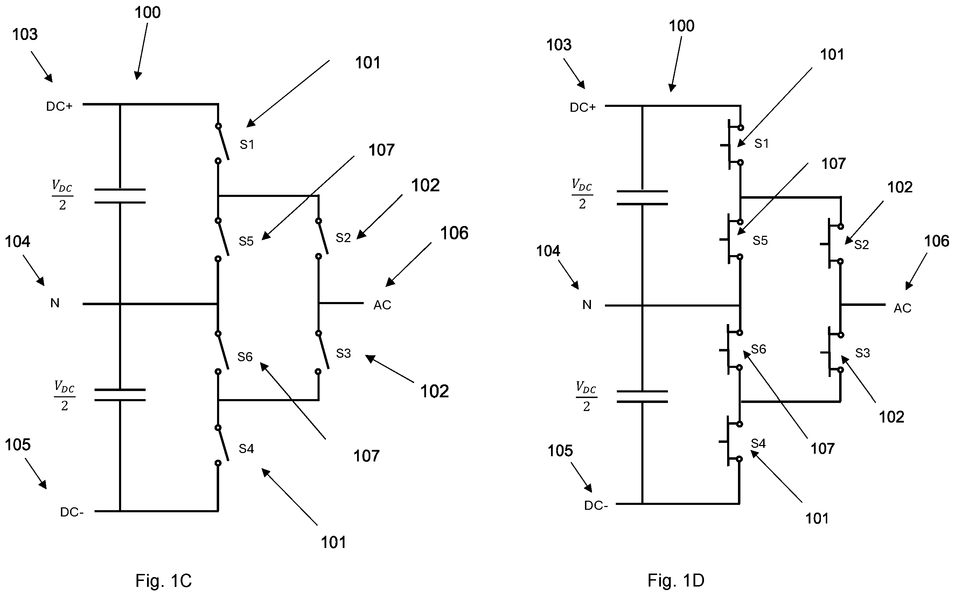

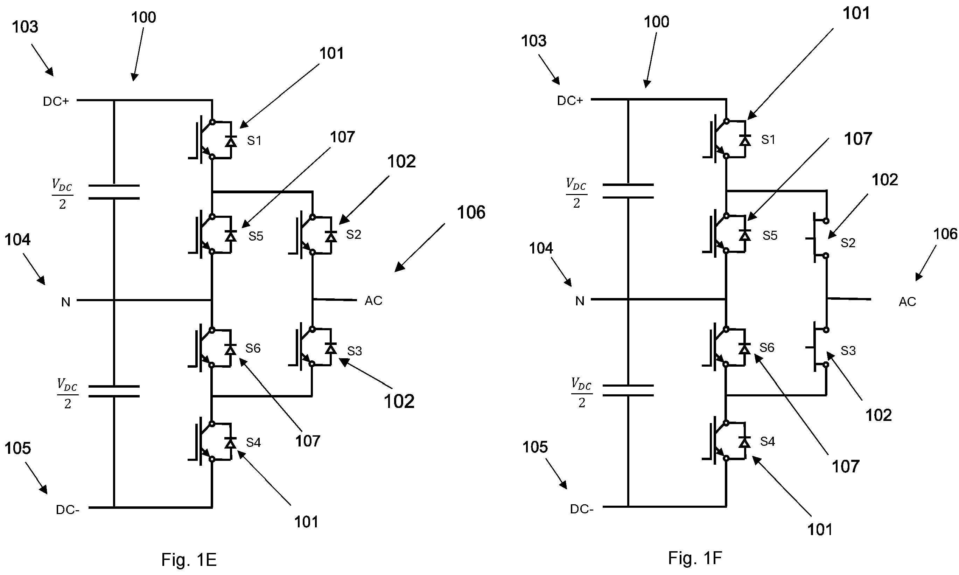

While not shown in Figures 1A and 1B, all of the switches in the electric circuit diagram (10) must be able to transfer current in both directions. Some switch types, such as GaN HEMT, SiC MOSFET (Silicon Carbide Metal Oxide Semiconductor Field-Effect Transistor), RC-IGBT and Si MOSFETs, are capable of passing the current in both directions. However, other switch types, such as a Si IGBT, is only capable of passing current in one direction. For these other types, they must then be accompanied by a secondary device to allow for a current to pass in the opposite direction, also known as an anti-parallel diode. The choice of orientation of the Si IGBT and the corresponding anti-parallel diode in the switch may be decided upon based on the operating requirements. Figures 1C - 1F illustrate the different devices which may be implemented for the switches S1 - S6. Figure 1C illustrates bidirectional switches in general. Figure 1D discloses an embodiment where the switches S1 - S6 are all GaN HEMTs, and Figure 1E discloses an embodiment where switches S1 - S6 are all RC-IGBTs or IGBTs with an antiparallel diode. Provided that the switches are able to pass current in both directions, the switches do not have to be identical. As another embodiment, Figure 1F illustrates the configuration where switches S2 and S3 are HEMTs, and switches S1, S4, S5 and S6 are RC-IGBTs or IGBTs with an anti-parallel diode. Throughout this description, the term "HEMT" may be used to describe any type of HEMT, such as (but not restricted to): E-mode GaN HEMT, D-mode GaN HEMT, and cascode GaN.

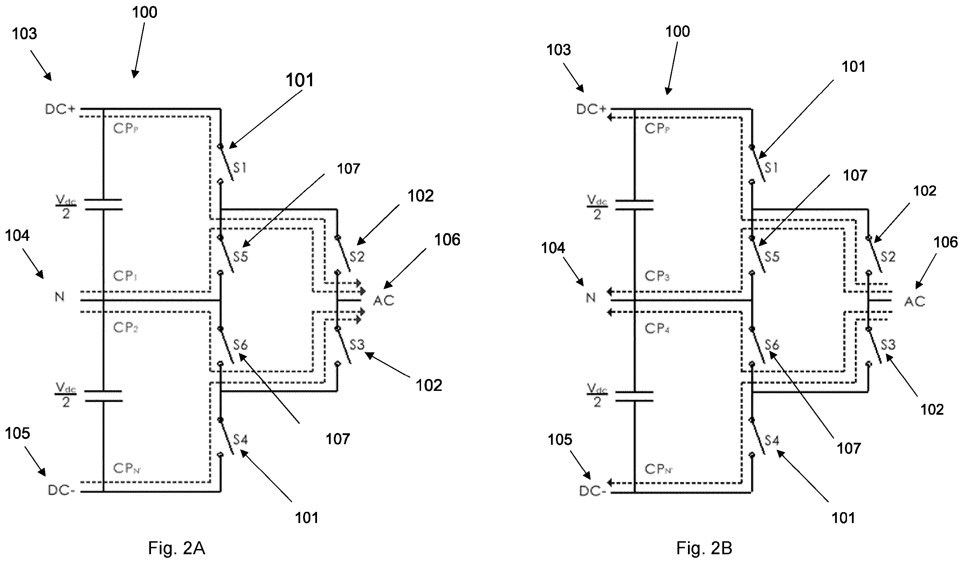

The path the current takes in the embodiments described in Figures 1A to 1F are shown in Figures 2A and 2B. Figure 2A discloses the situation when converting DC (at DC+ and DC-) to AC. In this situation, there are four possible paths the current can take (CPp, CP1, Cp2, CPN'). Figure 2B discloses the situation when converting AC to DC (at DC+ and DC-). In this situation, there are also four possible paths the current can take (CPp', CP3, CP4, CPN). Current paths CPp and CPp' are opposites of each other, and therefore the switches S1 and S2 are configured to pass current in both directions for these current paths. Similarly, current paths CPN' and CPN are also opposites of each other, and therefore switches S3 and S4 are also configured to pass current in both directions for the same reason. Current paths CP1 and CP3 are opposites of each other, and therefore switches S5 and S2 are configured to pass current in both directions for these current paths. Finally, current paths CP2 and CP4 are opposites of each other, and therefore switches S6 and S3 are configured to pass current in both directions for these current paths. Therefore, in order for these eight current paths to be realised in the electronic circuit (and module) the switches S1, S2, S3, S4, S5 and S6 must all be configured to be able to pass current in both directions.

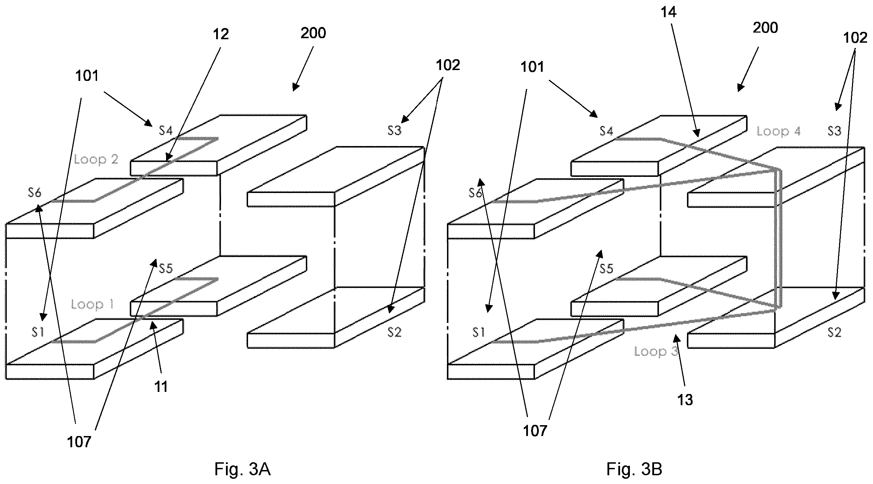

In Figure 3A & 3B the power module comprises a three-level active neutral point clamp topology is disclosed describing a physical layout that reduces the size of the commutation loops according to prioritisation based on consideration of their relative switching speeds in order to provide an improved power module configured in a 3L-ANPC topology.

Figures 3A and 3B depict the commutation loops 11, 12, 13 and 14, in a layered configuration 200, wherein Loop 1 (S1 and S5, commutation loop 11) and loop 2 (S4 and S6, commutation loop 12) in Figure 1A comprise two switches each. In the alternative, devices S5 and S6 may comprise diodes.

Loop 3 (S1, S2, S3 and S6, commutation loop 13) and loop 4 (S2, S3, S4 and S5, commutation loop 14) in Figure 1B comprise four switches each. In the alternative, devices S5 and S6 may comprise diodes. Further, in this diagram the power terminals are depicted, namely the Direct Current, DC, terminals, both DC+ 103 and DC⁻ 105 as well.

As Figures 1C - 1F depict the same circuit Figures 1A and 1B - albeit with different components, it can be readily understood that commutation loops 1 to 4 may also be possible in these embodiments.

In the following figures two examples are disclosed. The primary difference is the type of external terminal that is provided - horizontal or vertical. The examples are based on the use of switches S2 and S3 and switches S1, S4 and switches/diodes S5 and S6. With regards to electrical connections to the devices, only power connections have been illustrated for clarity, since optimisation of the commutation loops in the power circuit is primary the focus of the present disclosure.

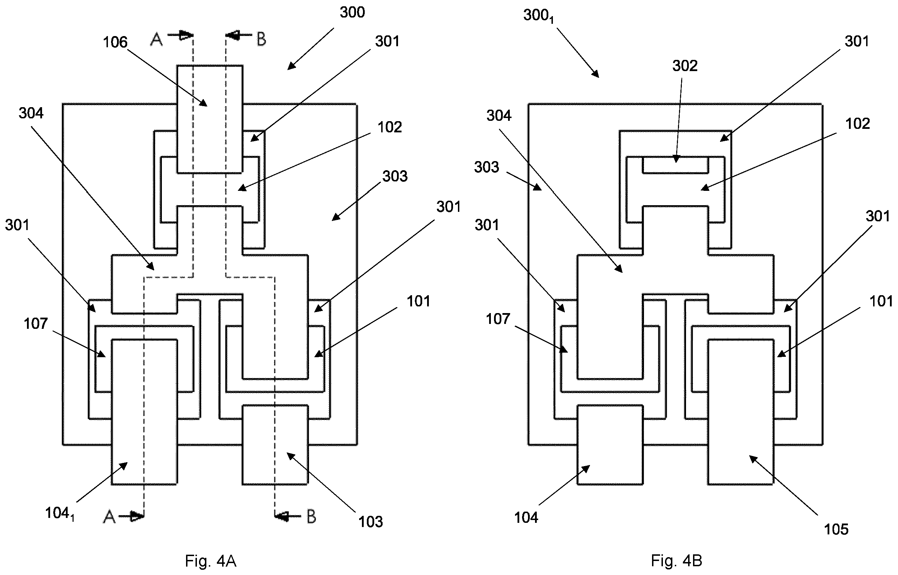

Two sub-assemblies are constructed as shown in Figures 4A and 4B. The two sub-assemblies 300 300₁ are a mirror image of one another with regards to the routing of the interconnections 304. Though they are not a mirror image of one another with regards to the N 104 104, and DC 103 105 terminals The provision of an external terminal for the AC connection 106 is another difference between the two sub-assemblies 300 300₁. In the case of the upper sub-assembly 300₁, the terminal is replaced with a conductive spacer 302. The assembly steps for the invention are now described.

First, an insulated substrate 301, 303 is provided. This is typically procured as a single component comprising an insulating middle layer 303 clad on both the upper surface and lower surface with conductive material. The conductive material on the upper surface is patterned to create isolated pads of conductor 301 onto which devices 101,102,107 are mounted. The conductive material on the lower side is used for heat transfer to an external cooling system. The conductive material may be copper or aluminium or another suitable material. The insulative material may be a ceramic, such as aluminium oxide, aluminium nitride or silicon nitride, or it may be a polymer-based insulator.

Second, the devices 101,102,107 are attached to the pads of conductor 301 on the upper surface of the substrate. Attachment may be performed by soldering, sintering or other appropriate processes. Finally, interconnections 304 between the devices 101,102,107 are formed, external terminals 103 104 104, 105 106 are added and a spacer 302 is attached. The interconnections 304 are illustrated as clip-like structures, however they could be realised by wire- or ribbon-bonding. The interconnections 304 may be formed from materials such as copper and/or aluminium.

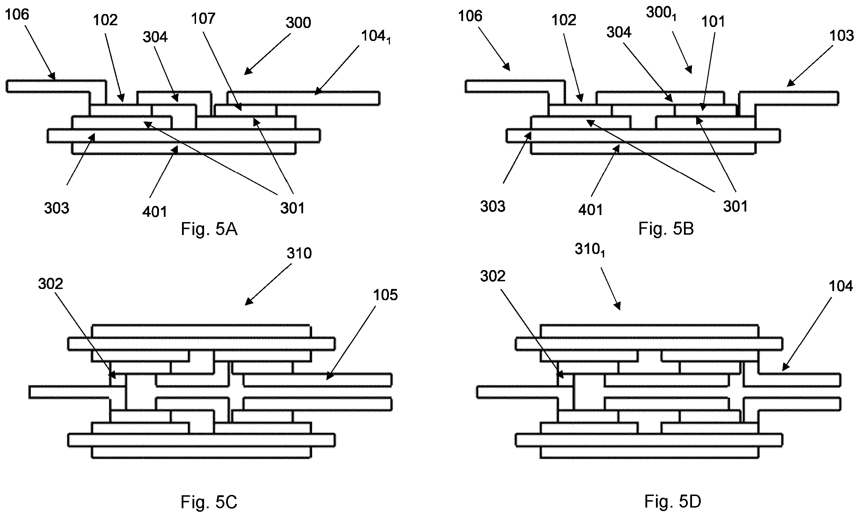

The external terminals in embodiment one are referred to as horizontal terminals and are oriented parallel to the direction of current flow through the module, as illustrated in Figure 5. In figure 5A and 5B, the profile view of the figure shown in Figure 4A and 4B, respectively, are shown. Here the insulated substrate 303 is depicted with conductive patterned layer 301 attached and with a conductive layer 401 attached at the other side of the insulated substrate 303

Only external terminals 103, 104, 104₁, 105 and 106 for the power connections (i.e. DC+, DC-, N and AC in Figure 1) are shown for clarity. However, similar terminals will also be provided for the control circuit connections, which will include a gate connection for each device and possibly a separate connection to the source or emitter of each device, often referred to as a Kelvin source or auxiliary emitter connection.

Final assembly of embodiment one is illustrated in Figure 5C and 5D. The upper sub-assembly 300₁ is inverted and stacked on top of the lower sub-assembly 300. A conductive connection is formed between the devices in positions S5 and S6 through the spacer 302 and external terminal 106. Support and separation of the sub-assemblies 300 300₁ may be provided by additional spacer components (not shown). The spacer components may be insulative or they may be conductive providing their use does not short-circuit one or more of the devices.

Encapsulation in an insulative material is typically required for the module to function reliably at its rated voltage. Commonly used encapsulation materials are epoxy-based resins, although other appropriate insulative materials could be used, such as silicones.

It is feasible to perform the encapsulation process either prior to or following the stacking of the sub-assemblies 300 300₁. Encapsulation prior to stacking creates two separate encapsulated modules, each containing three of the six required devices, which are then stacked during construction of the circuit by the eventual assembler. Among the advantages of this approach are the simplification of the geometry to be encapsulated and a reduced component count for each encapsulation process, which lowers costs associated with manufacturing yields. Encapsulation following stacking creates a single encapsulated module. The advantage of this approach is that it creates a single module that includes all components in the topology and can be tested to verify its full functionality.

For improved electrical performance, it is desirable that interconnections 304 and external terminals contact the devices directly, however it may be necessary for the purposes of manufacturability and/or reliability for these elements to touch down on additional conductive pads on the substrate as an intermediate step (not shown).

This embodiment realises the advantages of the layout concept described in relation to Figures 3A and 3B. The advantage of providing horizontal terminals is that they are commonplace, easily manufactured and routinely and reliably incorporated in typical power electronics assemblies.

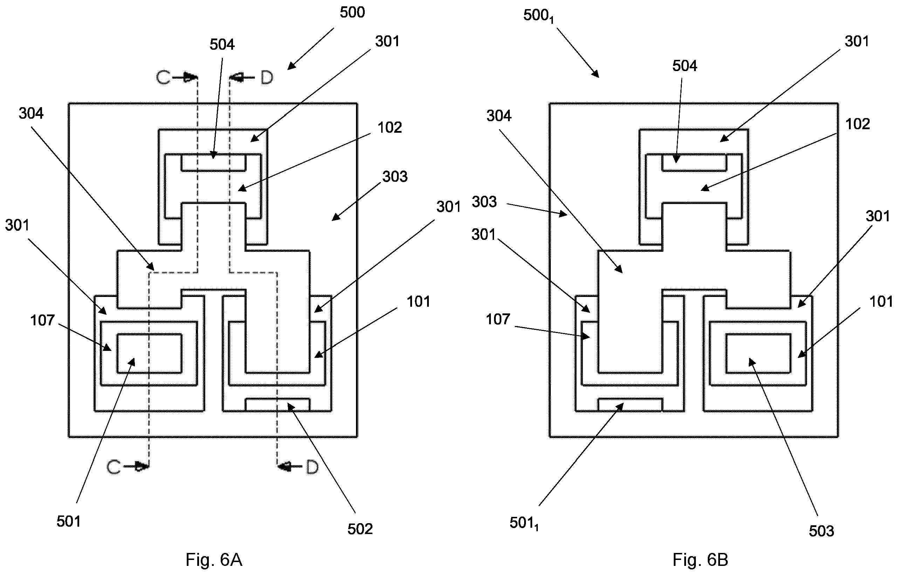

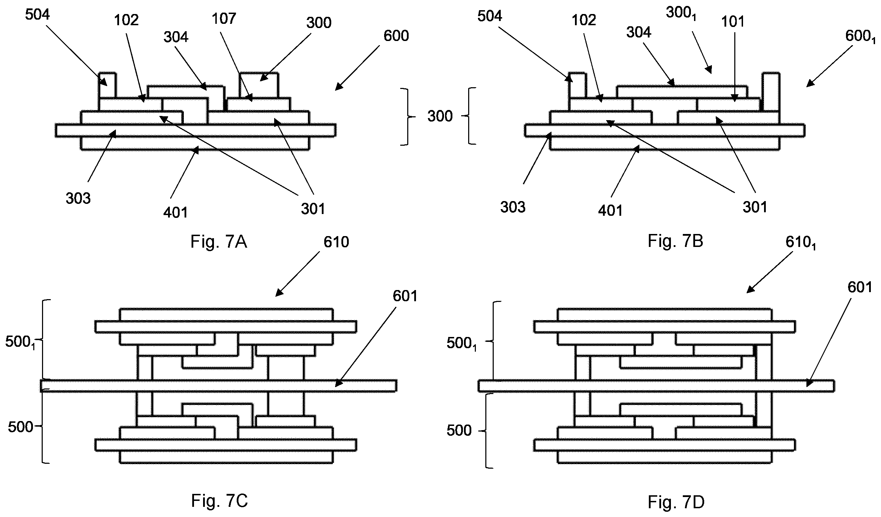

In an example of the present disclosure two sub-assemblies are constructed as shown in Figures 6A and 6B. The two sub-assemblies 500 500₁ are a mirror image of one another, except for functionality of the external terminals, that is N, 501 501₁ and DC 502 503. As in embodiment one, insulated substrates are used, devices are attached to pads of conductor 301 on the upper surface of the substrates 303 and interconnections 304 are formed between the devices. In contrast to embodiment one, vertical external terminals are provided, as illustrated in Figure 7. Terminals making control circuit connections to the devices are not shown, but vertical connections may be included for these also.

The primary advantage of using vertical terminals is that the connection distance between the devices and external circuitry is reduced, so the parasitic inductance relating to the external terminals is lowered. In addition, the overall footprint of the module can be reduced since the external terminals do not extend beyond the outline of the substrates.

Final assembly of embodiment two is illustrated in Figures 7C and 7D. The upper sub-assembly 500₁ is inverted and stacked on top of the lower sub-assembly 500 with a central substrate 601, such as a printed circuit board or conductive lead frame between the two sub-assemblies 500 500₁.

This central substrate 601 provides connection between the vertical terminals and external circuitry. Conductive connections are formed between the sub-assemblies 500 500₁ and the central substrate 601 by an appropriate method, such as soldering, sintering or dry pressure contact. A conductive connection is formed between the devices 101, 102 and 107 through external terminals, 501, 501₁, 502, 503 and 504 and the central substrate 601.

Encapsulation can be performed either before or after the stacking process. The same advantages apply for each approach, as described for embodiment one. The choice of connection technology between the terminals 501 501₁ 502 503 504 and central substrate 601 must be compatible with the encapsulation approach. For example, dry pressure contact would not be suitable for encapsulation of the module as one component, since encapsulation material may penetrate the dry contact interface, increasing its electrical resistance.

Several modifications that can applied to either embodiments one or two are now described. In the previous embodiments, the sub-assemblies comprised both vertical switches and lateral switches. This results from the connection of the interconnection and the switch, when a vertical connection is seen, as can be seen in Figure 5A, the right side of the interconnection 304, while a lateral connection is depicted by the left side of the interconnection 304. These different types of switches may be used in different embodiments as mentioned above and will be mentioned below.

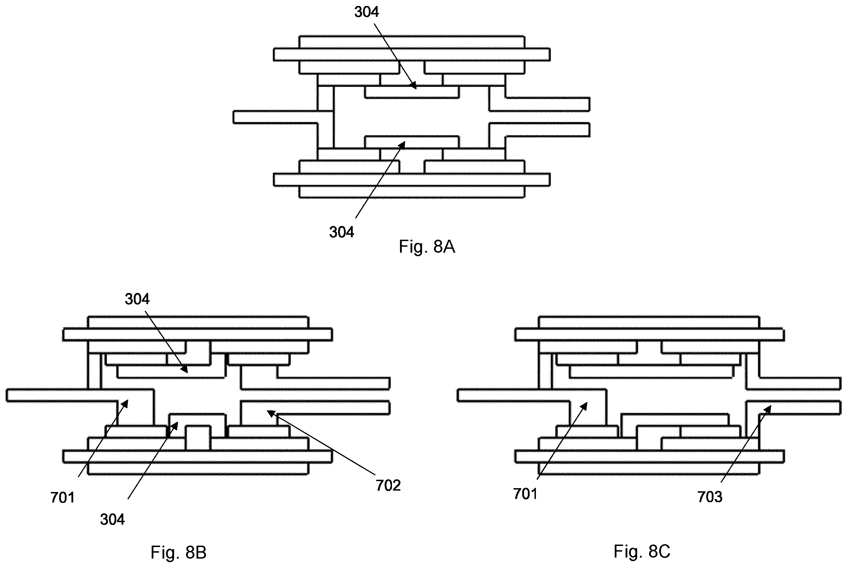

Figure 8A illustrates the assembly constructed with lateral switches/devices. As a consequence, connection points for the interconnections 304 and the external terminals 106 103 104 302 are changed.

Figures 8B and 8C illustrates the assembly constructed with vertical switches/devices. As a consequence, connection points for the interconnections 304 and external terminals 701 702 703 are changed.

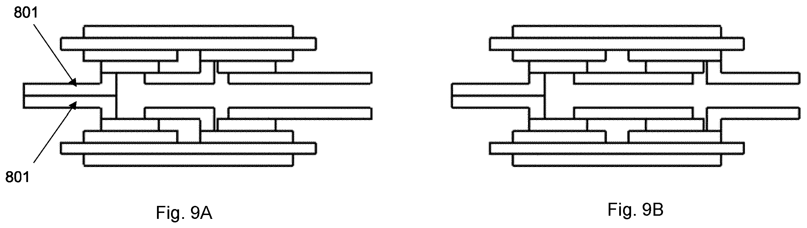

Figures 9A and 9B depict a modification of Figures 5C and 5D in which external horizontal terminals for the AC connection 801, 801 (which is the same as reference number 106 in Figure 5A and 5B) are included in both the upper and lower sub-assemblies. The advantage in this approach is that the upper and lower sub-assemblies can be fixed together by mechanical means such as screws.

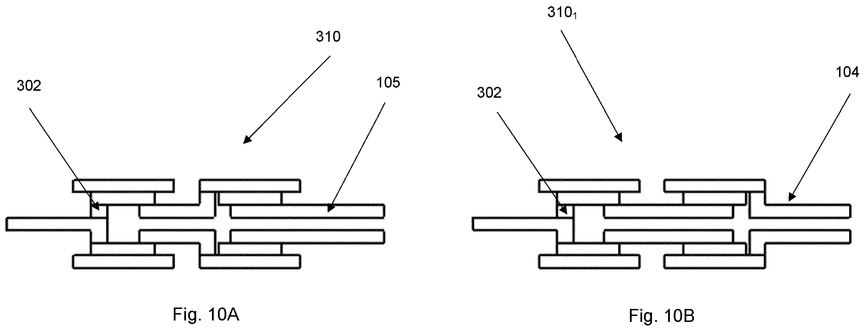

Figure 10A and 10B show an assembly like that shown in Figures 5A & 5B, however the devices are mounted on isolated conductor pads 301. The other two layers (303, 401) of the insulated substrate are omitted. This approach may reduce material costs and may have the potential to reduce the thermal impedance between the devices and the external surface of the module.

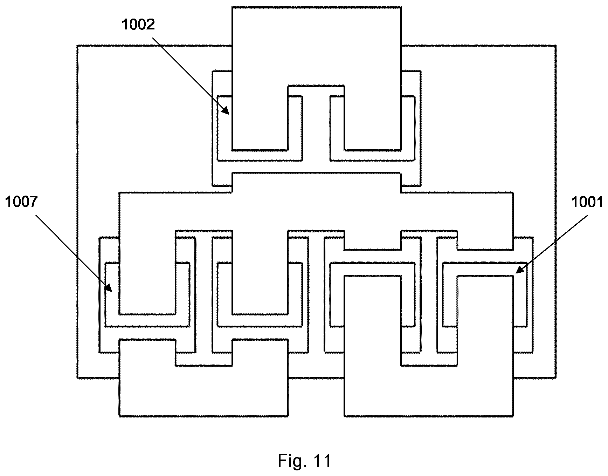

Figure 11 illustrates a modification to the subassemblies of the embodiments depicted in Figures 4A and 4B, where now there are now two devices (1001, 1002, 1007) in parallel using horizontal terminals (instead of one (101, 102, 107) in Figures 4A and 4B), arranged laterally to the direction of the current flow, in each switch position. The parallel devices (1001, 1002, 1007) may be of the same type, such as RC-IGBT (Reverse-conducting IGBT) semiconductor devices, or may be of different types, for example an IGBT and a diode. Two parallel semiconductor devices (1001, 1002, 1007) are shown in each switch position, but more than two devices (or chips) can be connected in parallel. The illustration shows the interconnection scheme for vertical semiconductor devices, but a similar modification can be applied with lateral semiconductor devices.

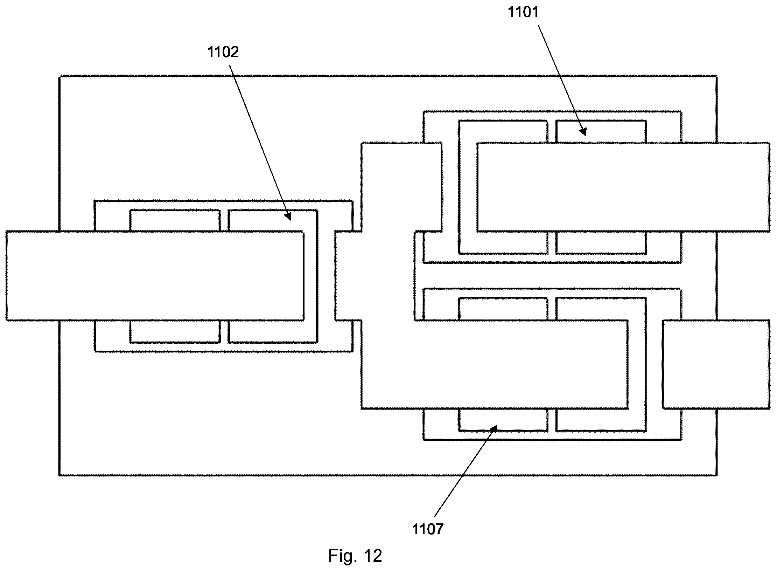

Figure 12 shows an alternative modification to the assemblies of the embodiments depicted in Figures 4A and 5B applying parallel devices and horizontal terminals. In this modification the devices (1101, 1102, 1107) are arranged longitudinally (or in series) relative to the direction of current flow.

A hybrid of embodiments one and two may be realised, whereby horizontal terminals are provided for the power connections and vertical terminals are provided for control connections or vice-versa. Using vertical terminals for control connections may particularly be advantageous where parallel devices are used in switch position.

When using the term "devices" it may refer to chips which may embody switches or diodes when appropriate.

The present disclosure and therein the embodiments mentioned above will decrease the parasitic inductance in the power module, thereby solving the problem noted from the prior art.

As noted above, particular terminology used when describing certain features or aspects of the technology should not be taken to imply that the terminology is being redefined herein to be restricted to any specific characteristics, features, or aspects of the technology with which that terminology is associated. In general, the terms used in the following claims should not be construed to limit the technology to the specific examples disclosed in the specification, unless the Detailed Description section explicitly defines such terms. Accordingly, the actual scope of the technology encompasses not only the disclosed examples, but also all equivalent ways of practicing or implementing the technology under the claims.

## Claims

1. A power module comprising a three-level active neutral point clamp topology comprising:
- at least six devices comprising two inner switches (S2, S3), two outer switches (S1, S4) and two clamping devices (S5, S6), wherein:
- a first of said two outer switches is connected to a positive Direct Current, DC+, terminal, and a second of said two outer switches is connected to a negative DC, DC-, terminal;
- a first of said two inner switches is connected to the first outer switch and to an Alternating Current, AC, terminal and wherein a second of said two inner switches is connected to the second outer switch and said AC terminal;
- a first of said two clamping devices is connected to said first outer switch and to a neutral terminal (N), and wherein a second of said two clamping devices is connected to said second outer switch and to said neutral terminal (N);
- a sandwich structure comprising:
- a first sub-assembly, wherein the first sub-assembly comprises the first inner switch, the first clamping device and the first outer switch;
- a second sub-assembly, wherein the second sub-assembly comprises the second inner switch, the second clamping device and the second outer switch;
wherein the sandwich structure is arranged such that the first inner switch faces the second inner switch, such that the first outer switch faces the second clamping device and such that the first clamping device faces the second outer switch;
- a conductive connection element connecting the first and second inner switches.

2. The power module according to claim 1, wherein the two inner switches comprise GaN HEMT transistors and the two outer switches and the two clamping devices comprise Si IGBTs and a corresponding anti-parallel diode.

3. The power module according to any of the previous claims wherein the first sub-assembly comprises:
- a first interconnect arranged for connecting the first inner switch with the first outer switch and with the first clamping device.

4. The power module according to any of the previous claims wherein the second sub-assembly comprises:
- a second interconnect arranged for connecting the first inner switch with the first outer switch and with the first clamping device.

5. The power module according to any of the claims 3 and 4, wherein the first and/or second interconnect comprises a clip-like structure, or a wire- or ribbon-bonding comprising of copper and/or aluminium.

6. The power module according to any of the previous claims, wherein the power module further comprises:
- a central substrate positioned in between the first and second sub-assembly, wherein the central substrate comprises the AC terminal, the positive DC terminal, the negative DC terminal and the neutral terminal.

7. The power module according to claim 6, wherein the central substrate comprises any of a printed circuit board or a conductive lead frame.

8. The power module according to any of the previous claims, wherein said power module comprises a duplicated switch for duplicating one of said at least six devices, wherein said duplicated switch is placed in parallel or in series of said one of said at least six devices.

9. The power module according to claim 8, wherein said duplicated switch is of a same type as said one of said at least six devices.

10. A method of manufacturing a power module in accordance with any of the previous claims, wherein the method comprises the steps of:
- providing the first sub-assembly;
- providing the second sub-assembly;
- sandwiching the first sub-assembly and the second sub-assembly such that a sandwich structure is obtained, wherein the sandwich structure is arranged such that the first inner switch faces the second inner switch, such that the first outer switch faces the second clamping device and such that the first clamping device faces the second outer switch.

11. The method according to claim 10, wherein the method comprises the step of:
- providing a first interconnect at said first sub-assembly, such that said first interconnect connects the first inner switch with the first outer switch and with the first clamping device.

12. The method in accordance with any of the claims 10 - 11, wherein the method further comprises the step of:
- providing a second interconnect at said second sub-assembly, such that said first interconnect connects the first inner switch with the first outer switch and with the first clamping device.

13. The method in accordance with any of the claims 10 - 12, wherein the method further comprises the step of:
- providing a central substrate positioned in between the first and second sub-assembly, wherein the central substrate comprises the AC terminal, the positive DC terminal, the negative DC terminal and the neutral terminal.

14. Assembly of the power module according to any of the claims 1-9, wherein the sandwich structure is encapsulated, wherein the encapsulation comprises an insulating material comprising epoxy-based resins, silicones or other insulative materials.

15. Assembly in accordance with claim 14, wherein the first sub-assembly and the second sub-assembly are each encapsulated separately.
